# Europäisches Patentamt

## European Patent Office

## Office européen des brevets

(11) Publication number: **0 086 845**
**B1**

(12) ## EUROPEAN PATENT SPECIFICATION

(45) Date of publication of patent specification: **12.10.88**

(51) Int. Cl.⁴: **H 04 N 5/30**

(21) Application number: **82902547.7**

(22) Date of filing: **27.08.82**

(86) International application number:
**PCT/JP82/00342**

(87) International publication number:
**WO 83/00969 17.03.83 Gazette 83/07**

(54) SOLID STATE IMAGE PICKUP DEVICE.

(30) Priority: **29.08.81 JP 135797/81**

(43) Date of publication of application:
**31.08.83 Bulletin 83/35**

(45) Publication of the grant of the patent:
**12.10.88 Bulletin 88/41**

(84) Designated Contracting States:
**DE FR GB NL**

(56) References cited:
**DE-A-3 119 032**
**GB-A-2 026 769**
**JP-A-51 060 186**
**JP-A-56 008 966**

**PATENTS ABSTRACTS OF JAPAN, vol. 5, no. 40 (E-49)712r, March 17, 1981; & JP - A - 55 163 963 (NIPPON DENKI K.K.) 20-12-1980**

(73) Proprietor: **SONY CORPORATION**
**7-35 Kitashinagawa 6-Chome Shinagawa-ku Tokyo 141 (JP)**

(72) Inventor: **TAKESHITA, Kaneyoshi**
**c/o Pat. Div., Sony Corp., 7-35 Kitashinagawa-6 Shinagawa-ku, Tokyo (JP)**
Inventor: **HASHIMOTO, Takeo**
**c/o Pat. Div., Sony Corp., 7-35 Kitashinagawa-6 Shinagawa-ku, Tokyo (JP)**

(74) Representative: **Thomas, Christopher Hugo et al**
**D Young & Co 10 Staple Inn London WC1V 7RD (GB)**

Courier Press, Leamington Spa, England.

## Description

This invention relates to solid state image pick-up devices.

Solid state image pick-up devices comprising a charge transfer device such as a charge coupled device (CCD) are classified broadly into the frame transfer type and the interline transfer type. Both types can be made small and light, and can operate with low power consumption and high reliability. However, previously proposed CCD image pick-up devices have problems with so-called 'blooming' and 'smear'.

To reduce deterioration in a reproduced picture caused by blooming, it has been proposed to provide an overflow drain in the CCD, to drain superfluous charges overflowing from photo-sensing elements contained in the device, in a light receiving period. However, such an overflow drain reduces the area of each photo-sensing element or the packing of the photo-sensing elements, so that the photo-sensitivity and image resolution of the device are reduced.

Accordingly, to reduce deterioration due to blooming and smear, a proposed solid state image pick-up device contains a photo-sensing and vertical transfer portion, and a horizontal transfer portion, both in a form similar to those in a CCD image pick-up device of the interline transfer type, and a storage portion in a form similar to that in a CCD image pick-up device of the frame transfer type, between the photo-sensing and vertical transfer portion and the horizontal transfer portion, wherein signal charges in vertical transfer portions contained in the photo-sensing and vertical transfer portion are transferred to the storage portion at high speed, and each of the vertical transfer portions made vacant acts as the overflow drain during the light receiving period. Such a solid state image pick-up device is referred to hereinafter as a solid state image pick-up device of hybrid transfer type.

In a hybrid transfer type device, signal charges read out to the vertical transfer portions from photodetectors contained in the photo-sensing and vertical transfer portions are transferred to the storage portion at high speed, and the signal charges transferred to the storage portion are further transferred to the horizontal transfer portion from the storage portion in turn at every period corresponding to a horizontal blanking period. Each of the vertical transfer portions, from which the signal charges have been transferred to the storage portion, acts as the overflow drain for excessive charges overflowing from the photodetectors and unwanted charges leaking into the vertical transfer portions, during the light receiving period. Then, prior to a reading out period, in which the signal charges stored in the photodetectors are read out to the vertical transfer portions, unwanted charges remaining in the vertical transfer portions are transferred to bs swept out therefrom. Consequently, the signal charges transferred to the storage portion from the vertical transfer portions do not contain the unwanted charges therein, and since the transfer of the signal charges to the storage portion in the vertical transfer portions is carried out at high speed, unwanted charges leaking into the signal charges during the transfer period are reduced. As a result, there is less deterioration due to blooming and smear.

However, in this hybrid transfer type device, the charge transfer for sweeping out the unwanted charges in the vertical transfer portions is required to be performed in the direction opposite to the direction of the charge transfer of the signal charges to the storage portion, and this means that driving circuits for causing the vertical transfer portions and the storage portion to perform the charge transfers become complicated. In addition, the photodetectors and the vertical transfer portions must have superfluous charge capacity for handling the excessive charges during the transfer period, and this means that only, for example 50% or less of the maximum charge which can be handled by the device can be used as the signal charge.

Japanese patent abstract JP 56-8966 discloses a solid state image pick-up device in accordance with the pre-characterizing part of claim 1.

According to the present invention there is provided a solid state image pick-up device comprising:

a substrate on which are provided:

photodetectors;

vertical transfer portions;

transfer gate areas each provided between one of said photodetectors and the corresponding one of said vertical transfer portions;

a storage portion;

a horizontal transfer portion; and

an output portion;

wherein signal charges obtained in said photodetectors during a light receiving period are read out through said transfer gate areas to said vertical transfer portions during a reading out period, then transferred from said vertical transfer portions to said storage portion at high speed, and further transferred through said horizontal transfer portion to said output portion;

characterized in that:

a region of high impurity concentration relative to that of said substrate is provided including said transfer gate areas and surrounding each of said vertical transfer portions, so that said transfer gate areas and other portions in said region of high impurity concentration positioned around each of said vertical transfer portions can be kept in an accumulation state during the operating period except for during the reading out period.

The invention will now be described by way of example with reference to the accompanying drawings, throughout which like parts are referred to by like references, and in which:

Figure 1 is a schematic plan view of an embodiment of solid state image pick-up device according to the present invention;

Figure 2 shows an enlarged portion of Figure 1;

Figure 3 is a section on line III—III in Figure 2; and

Figure 4 is a waveform diagram of driving signals.

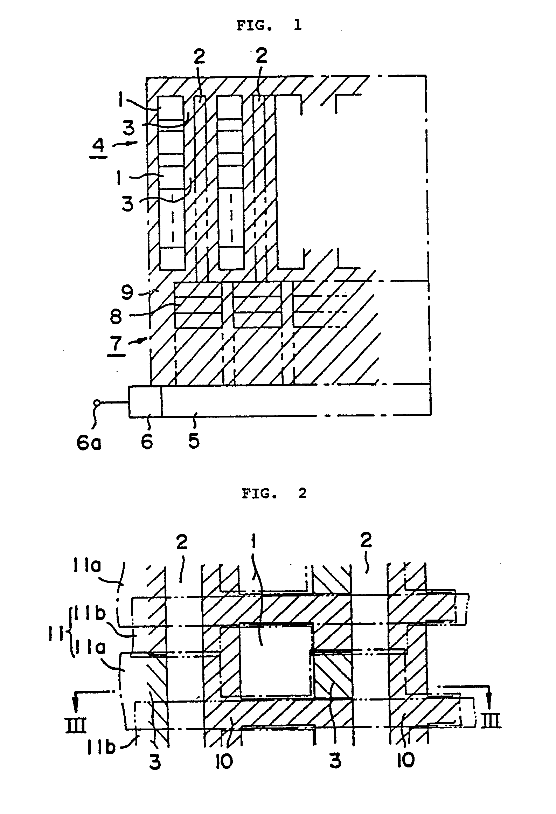

The embodiment of solid state image pick-up shown in Figure 1 comprises a photo-sensing and vertical transfer portion 4 which includes a plurality of photodetectors 1 arranged in horizontal and vertical rows and vertical transfer portions 2 each formed with, for example, a group of CCDs and extending along each of the vertical rows of photodetectors 1, and is provided with transfer gate areas 3 each positioned between each of the vertical rows of photodetectors 1 and the corresponding one of the vertical transfer portions 2, a horizontal transfer portion 5 formed with, for example, another group of CCDs, an output portion 6 coupled with the horizontal transfer portion 5, and a storage portion 7 formed with a further group of CCDs and provided between the photo-sensing and vertical transfer portion 4 and the horizontal transfer portion 5, all formed on a semiconductor substrate. The storage portion 7 is connected to one end of each of the vertical transfer portions 2 and contains therein a plurality of horizontal rows 8 of storing and transfer areas equal to the number of horizontal rows of photodetectors 1. A signal output terminal 6a is connected to the output portion 6. These portions and areas except each vertical row of the photodetectors 1 are covered by a shielding layer 9.

Predetermined vertical transfer clock signals are applied to the vertical transfer portions 2 and the storage portion 7, respectively, and a predetermined horizontal transfer clock signal is applied to the horizontal transfer portion 5, so that charge transfer operations occur. For example, signal charges in the photodetectors 1 due to the light received thereby for one field period are read out to the vertical transfer portions 2 according to a reading pulse signal applied to the transfer gate areas 3, and are then transferred from the vertical transfer portions 2 to the storage portion 7 at high speed, so that the signal charges produced in each horizontal row of the photodetectors 1 are transferred to the corresponding one of the horizontal rows 8 of storing and transfer areas in the storage portion 7. The signal charges transferred to each one of the horizontal rows 9 are transferred in turn to the horizontal transfer portion 5 at each period corresponding to a horizontal blanking period, and then transferred to the output portion 6 during a period corresponding to a horizontal video period. As a result, an image pick-up signal output is obtained at the output terminal 6a.

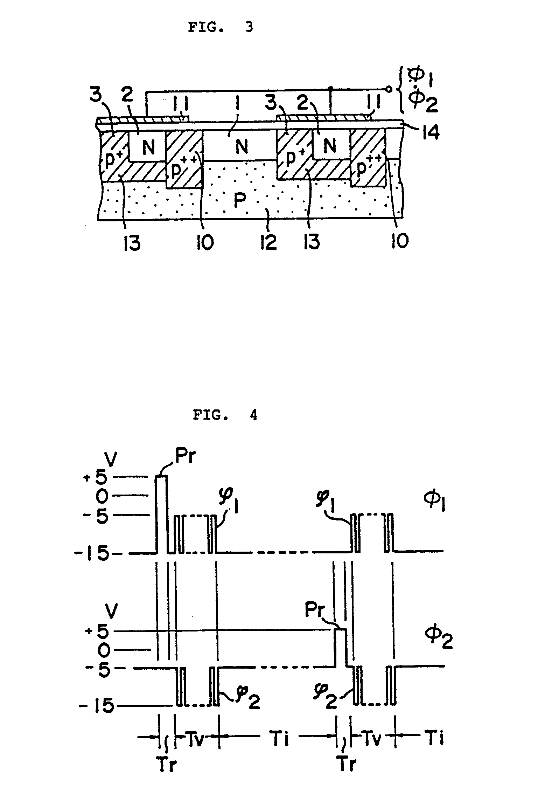

The photo-sensing and vertical transfer portion 4 has the transfer gate areas 3 between each vertical row of photodetectors 1 and the corresponding one of the vertical transfer portions 2, and channel stop areas 10 at positions contiguous to the photodetectors 1 in the side opposite to the transfer gate areas 3 and between each two adjacent photodetectors 1, as shown in Figure 2. On each horizontal row of pick-up units each containing one of the photodetectors 1, one horizontally-elongated vertical transfer electrode 11 is provided. Each of the vertical transfer electrodes 11 is extended to cover the transfer gate areas 3 so as to form transfer gate electrodes at portions thereof, and is composed of a charge storing electrode 11a and a potential barrier electrode 11b. The reading pulse signal is supplied in turn to the vertical transfer electrodes 11, and two-phase vertical transfer clock signals are respectively supplied to the groups of every other vertical transfer electrode 11.

The distinctive features in configuration of the embodiment can be seen in Figure 3. The photodetectors 1 and vertical transfer portions 2 are provided in the form of semiconductor regions of N type in a semiconductor substrate 12 of, for example, P type. Each of the vertical transfer portions 2 is formed with a group of buried channel CCDs and is surrounded by a P type semiconductor region 13 of high impurity concentration and including the transfer gate areas 3, and a P type semiconductor region having high impurity concentration and forming the channel stop areas 10. An insulating layer 14 is provided on the whole of these portions and regions, and on the insulating layer 14, the vertical transfer electrodes 11 including the transfer gate electrodes are provided over the respective vertical transfer portions 2 and the respective transfer gate areas 3, respectively.

A driving signal $\phi_1$ as, for example, shown in Figure 4 is supplied to every other vertical transfer electrode 11 and a driving signal $\phi_2$ is also supplied to every other vertical transfer electrodes 11. The driving signal $\phi_1$ contains a reading pulse signal $P_r$ at every other reading out period $T_r$ and a vertical transfer clock signal $\phi_1$ during each vertical transfer period $T_v$, and takes a negative level, for example, $-15$ V during each light receiving period. The driving signal $\phi_2$ contains the reading pulse signal $P_r$ at another every other reading out period $T_r$ and a vertical transfer clock signal $\phi_2$, which is opposite in phase to the vertical transfer clock signal $\phi_1$, during each vertical transfer period $T_v$, and takes a negative level, the absolute value of which is smaller than that of the driving signal $\phi_1$, for example, $-5$ V during each light receiving period. The reading pulse signal $P_r$ takes a positive level, for example $+5$ V and the vertical transfer clock signals $\phi_1$ and $\phi_2$ which are opposite in phase to each other are formed in negative pulse trains of high and low levels, for example, $-5$ V and $-15$ V.

The operation will now be explained.

During the reading out period $T_r$ in which the reading pulse signal $P_r$ in the driving signal $\phi_1$ or $\phi_2$ is supplied to the vertical transfer electrode 11, the potential of the transfer gate areas 3 becomes high and consequently signal charges stored in the photodetectors 1 are read out through the transfer gate areas 3 to the vertical transfer portions 2. Next, during the vertical transfer period $T_v$, the vertical transfer clock signals $\phi_1$ and $\phi_2$ are supplied to respective every other vertical transfer electrode 11, so that the signal charges read out from the photodetectors 1 are transferred to the storage portion 7 at high speed. Then, during the light receiving period $T_l$ following the vertical transfer period $T_v$, the vertical transfer electrodes 11 are supplied with the negative voltages (−15 V and −5 V) of the driving signals $\phi_1$ and $\phi_2$, and the photodetectors 1 produce and store signal charges in response to the amount of the light received thereby. After that, the reading out period $T_r$ follows again, and each step of the above mentioned operation is repeated.

In this operation, the transfer gate areas 3 formed into the P type semiconductor region having high impurity concentration are supplied with the negative voltage (−5V or −15 V) during the vertical transfer period $T_v$, and the light receiving period $T_l$ other than the reading out period $T_r$ in which the transfer gate areas 3 are supplied with the reading pulse signal $P_r$ taking the positive voltage (+5 V), and consequently are kept in an accumulation state in which holes are stored therein during the vertical transfer period $T_v$ and the light receiving period $T_l$. Accordingly, excessive charges produced in response to light excessively entering the photodetectors 1 during the light receiving period $T_l$ are diffused to the substrate 12, because the hole density in the P type semiconductor regions 13 including the transfer gate areas 3 kept in an accumulation state and positioned around the respective vertical transfer portions 2 is higher than that in the semiconductor substrate 12, so that the excessive charges scarcely flow into the vertical transfer portions 2.

If the impurity concentration in the semiconductor substrate 12 is p, for example, $5 \times 10^{14}$ cm$^{-3}$ and the impurity concentration in the P type semiconductor region 13 is p$^+$, for example $2 \times 10^{16}$ cm$^{-3}$, the ratio of the charges flowing into the vertical transfer portions 2 to the charges moving to the semiconductor substrate 12 is p/p$^+$, for example, 1/40. This effectively reduces the excessive charges flowing into the vertical transfer portions 2, without providing an overflow drain, and it is not required to perform charge transfer for sweeping out unwanted charges remaining in the vertical transfer portions 2 before the signal charges stored in the photodetectors 1 during the light receiving period $T_l$ are read out to the vertical transfer portions 2. The vertical transfer portions 2 are covered by the shielding layer 9 and therefore light does not enter them directly.

In addition, during the light receiving period $T_l$, the areas corresponding to the respective photodetectors 1 of the vertical transfer portions 2 are alternately supplied with the negative voltages of different magnitudes, for example, −15 V and −5 V as fixed bias voltages, so that the charge transfer operations is not performed in the vertical transfer portions 2 and, since the areas of low potential and the areas of high potential are arranged alternately in each of the vertical transfer portions 2, the unwanted charges tending to flow into the vertical transfer portions 2 are stored at the respective areas into which the charges have undesirably flowed. Consequently, blooming is reduced. The blooming would be caused in such a case if the areas of high potential in the vertical transfer portions 2 were saturated by the unwanted charges flowing into the vertical transfer portions 2 during the light receiving period $T_l$. If the amount of the excessive charge produced in response to excessive light entering the photodetectors 1 is $i_o$, the ratio of a part of the excessive charges flowing towards a rear surface of the substrate 12 opposite to the photodetectors 1 to the whole excessive charges is α, a part of the excessive charge flowing into the vertical transfer portions 2 which is referred to as $i_o'$, is represented by:

$$(1 - \alpha) \cdot (p/p^+) \cdot i_o.$$

Hereupon, further supposings $p/p^+ = 1/40$, and $\alpha = 0.8$, $i_o$ is $i_o/200$. Accordingly, blooming is effectively suppressed if the amount of light entering the photodetectors 1 is less than two hundred times the amount of light producing the unwanted charges which flow into the vertical transfer portions 2 and by which the areas of high potential in the vertical transfer portions 2 are saturated.

Moreover, during the vertical transfer period $T_v$, the transfer gate areas 3 are supplied with the negative voltage so as to be kept in the accumulation state, and the P type semiconductor regions 13 are operative in the same manner as during the light receiving period $T_l$, so that the unwanted charges flowing into the vertical transfer portions 2 are much reduced. Therefore, smear due to the vertical transfer of the unwanted charges flowing into the vertical transfer portions 2, and causing white stripes on a picture obtained in response to the image pick-up signal output, is effectively suppressed.

Moreover, since it is not required for the photodetectors 1 and the vertical transfer portions 2 to have additional charge capacity for handling the excessive charges, the whole of the charge capacity of the photodetectors 1 and the vertical transfer portions 2 can be utilised for the signal charges, and therefore the dynamic range of the image pick-up signal output can be increased or the driving signals can be reduced in amplitude, so simplifying the driving circuit arrangement.

Incidentally, since the vertical transfer portions 2 are formed with the buried channel CCDs in the above described embodiment, the signal charges are transferred very effectively in the vertical transfer portions 2 during the vertical transfer period $T_v$.

Embodiments of the inventions are particularly, but not exclusively, suitable for use in high-grade television cameras of small size and weight.

**Claims**

1. A solid state image pick-up device comprising:

a substrate (12) on which are provided:

photodetectors (1);
vertical transfer portions (2);
transfer gate areas (3) each provided between one of said photodetectors (1) and the corresponding one of said vertical transfer portions (2);
a storage portion (7);
a horizontal transfer portion (5); and
an output portion (6);
wherein signal charges obtained in said photodetectors (1) during a light receiving period are read out through said transfer gate areas (3) to said vertical transfer portions (2) during a reading out period, then transferred from said vertical transfer portions (2) to said storage portion (7) at high speed, and further transferred through said horizontal transfer portion (5) to said output portion (6);
characterized in that:
a region (13) of high impurity concentration relative to that of said substrate is provided including said transfer gate areas (3) and surrounding each of said vertical transfer portions (2), so that said transfer gate areas (3) and other portions in said region (13) of high impurity concentration positioned around each of said vertical transfer portions (2) can be kept in an accumulation state during the operating period except for during the reading out period.

2. A device according to claim 1 wherein said substrate (12) is of P type semiconductor material of impurity concentration $5 \times 10^{14}$ cm$^{-3}$, and said region (13) of high impurity concentration is of P type semiconductor material of impurity concentration $2 \times 10^{16}$ cm$^{-3}$.

**Patentansprüche**

1. Halbleiter-Bildaufnahmevorrichtung mit einem Substrat (12), auf dem vorgesehen sind:
—Photodetektoren (1),
—Vertikaltransferteile (2),
—Transfergate-Bereiche (3), wovon jeder zwischen einem der Photodetektoren (1) und dem korrespondierenden der Vertikaltransferteile (2) vorgesehen ist,
—ein Speicherteil (7),
—ein Horizontaltransferteil (5) und
—ein Ausgangsteil (6),
wobei Signalladungen, die in den Photodetektoren (1) während einer Lichtaufnahme-Periode gewonnen sind, während einer Auslese-Periode durch die Transfergate-Bereiche (3) zu den Vertikaltransferteilen (2) hin ausgelesen werden, dann bei hoher Geschwindigkeit von den Vertikaltransferteilen (2) zu dem Speicherteil (7) übertragen werden und weiter durch den Horizontaltransferteil (5) zu dem Ausgangsteil (6) übertragen werden,
dadurch gekennzeichnet, daß
ein Bereich (13) hoher Störstellenkonzentration relativ zu derjenigen des Substrats vorgesehen ist, der die Transfergate-Bereiche (3) enthält und jeden der Vertikaltransferteile (2) umgibt, so daß die Transfergate-Bereiche (3) und andere Teile in dem Bereich (13) hoher Störstellenkonzentration, die um jeden der Vertikaltransferteile (2) herum positioniert sind, während der Arbeits-Periode ausgenommen während der Auslese-Periode in einen Akkumulierungszustand gehalten werden kann.

2. Vorrichtung nach Anspruch 1, bei der das Substrat (12) aus p-Halbleitermaterial der Störstellenkonzentration von $5 \times 10^{14}$ cm$^{-3}$ besteht und der Bereich (13) hoher Störstellenkonzentration aus p-Halbleitermaterial der Störstellenkonzentration von $2 \times 10^{16}$ cm$^{-3}$ besteht.

**Revendications**

1. Dispositif de prise de vues du type état solide, comprenant:
un substrat (12) sur lequel sont disposés:
des photodétecteurs (1);
des parties de transfert vertical (2);
des zones de porte de transfert (3) qui sont chacune disposées entre l'un desdits photodétecteurs (1) et celle desdites parties de transfert vertical (2) qui lui correspond;
une partie d'emmagasinage (7);
une partie de transfert horizontal (5); et
une partie de sortie (6);
où les charges de signal obtenues dans lesdits photodétecteurs (1) pendant une période de réception de lumière sont lues et fournies via lesdites zones de porte de transfert (3) auxdites parties de transfert verticale (2) pendant une période de lecture, puis sont transférées desdites parties de transfert vertical (2) à ladite partie d'emmagasinage (7) avec une vitesse élevée, et sont de plus transférées via ladite partie de transfert horizontal (5) à ladite partie de sortie (6);
caractérisé en ce que:
il est prévu une région (13) à haute concentration en impureté par rapport à celle dudit substrat, laquelle contient lesdites zones de porte de transfert (3) en entoure chacune desdites parties de transfert vertical (2), si bien que lesdites zones de porte de transfert (3) et d'autres parties de ladite région (13) à haute concentration en impureté placées autour de chacune desdites parties de transfert vertical (2) peuvent être maintenues dans un état d'accumulation pendant la période de fonctionnement, sauf pendant la période de lecture.

2. Dispositif selon la revendication 1, où ledit substrat (12) est un matériau semiconducteur du type P ayant une concentration en impureté de $5 \times 10^{14}$ cm$^{-3}$, et ladite région (13) à haute concentration en impureté est un matériau semiconducteur de type P ayant une concentration en impureté de $2 \times 10^{16}$ cm$^{-3}$.

FIG. 1

FIG. 2

FIG. 3

FIG. 4